# EUROPEAN PATENT SPECIFICATION

(11) **EP 0 516 400 B1**
(45) Date of publication and mention of the grant of the patent: **30.07.1997**
(21) Application number: 92304806.0
(22) Date of filing: 27.05.1992
(51) Int. Cl.: H03H 9/19, H03H 9/05

(54) **Torsional quartz crystal resonator**
Drehschwingender Quarzkristallresonator
Résonateur à quartz vibrant selon un mode de torsion

(30) Priority: 27.05.1991 JP 121487/91; 27.05.1991 JP 121488/91; 26.09.1991 JP 247877/91; 27.09.1991 JP 249838/91
(43) Date of publication of application: 02.12.1992
(73) Proprietor: SEIKO ELECTRONIC COMPONENTS LTD., Sendai-shi, Miyagi-ken 982 (JP)
(72) Inventor: Kawashima, Hirofumi, Taihaku-ku, Sendai-shi, Miyagi (JP)
(74) Representative: Sturt, Clifford Mark

(56) References cited:
- EP-A- 0 365 268
- GB-A- 2 124 022
- US-A- 3 375 379

## Description

The present invention relates to a resonator, a cut angle, a thickness-to-width ratio Rzx, a shape and an excitation electrode structure such as a torsional quartz crystal resonator of the specific cut type which is called TT cut in this description. The present invention particularly relates to the torsional quartz crystal resonator of the type suitable for a clock signal source in various portable devices such as a wrist watch, a pager, an IC card and a vehicle wireless communication implement, in which the resonator is required to have a high accuracy, a compact size, good resistance to shock and at a reasonable price.

Previously a flexural mode quartz crystal resonator of a tuning fork type and a length extensional mode quartz crystal resonator in a frequency band of 200 kHz - 600 kHz have both been used. However, the flexural mode quartz crystal resonator of the tuning fork type utilizes an overtone, hence formation of electrodes is complicated and a serious loss of vibrational energy is caused through the support for the lead wires etc. Consequently, this type of resonator has the drawback of a relatively high series resistance R₁. On the other hand, the extensional mode quartz crystal resonator has an oscillating frequency which is reciprocal with the length of a vibrational arm of the resonator. Therefore, the resonator is enlarged in the relatively low frequency range below 600 kHz: thereby causing the drawback that scaling the size down is difficult. In view of these drawbacks, there has been desired for a long time a quartz crystal resonator of a new cut type which features an oscillating frequency in the range of 200 kHz - 600 kHz, a micronized compact size, a zero temperature coefficient, and an easy chemical etching process.

One type of proposed prior art resonator is shown in British Patent Publication No. 2124022A in which a quartz resonator of tuning fork type is shown having axes x', y', and z' produced from the axes x, y, z of the crystal by rotating through an angle φ about the x axis and then rotating through an angle θ having an angle of + or -45° about the resulting z' axis and having a length extending along the x' axis. Ranges of φ between 45 and -38° and +40 and +80°, with specific examples of -45.5° and +64.5° are suggested. It is suggested that use of these angles can result in the first and second order temperature co-efficients being low.

An object of the present invention is to provide a torsional quartz crystal resonator of a new cut type, defined by rotating a Z plate quartz crystal around the x-axis and rotating the quartz crystal around the z'-axis.

Another object of the present invention is to set an optimum range of the thickness-to-width ratio in a torsional quartz crystal resonator having good frequency temperature behaviour. Namely, the frequency temperature behaviour can be improved by optimumly setting the ratio of the thickness to the width of the resonator.

A further object of the present invention is to provide an excitation electrode structure having a reduced series resistance. Namely, the series resistance can be reduced by arranging the excitation electrode on a face of the resonator piece, normal to the z' -axis and by arranging a connection electrode on a side face of a vibrational portion of the resonator.

A still further object of the present invention is to provide a torsional quartz crystal resonator having a specific configuration effective to reduce the loss of vibration energy.

According to the present invention, in a first aspect, there is provided a torsional quartz crystal tuning fork resonator vibratable in a torsional mode, characterised by the resonator having a specific cut type defined such that a z plate quartz crystal normal to a z-axis is rotated around an x-axis by a cut angle φ in the range of -50° through +30°, and is further rotated around a resultant z'-axis by another cut angle θ in the range of -30° through -10° or +10° through +30° so as to form the torsional quartz crystal tuning fork resonator, the resonator having its length extending along a resultant y' axis, a thickness-to-width ratio (Rzx) within the range of 0.1 through 1.5, where width is in a direction of the resultant x' axis and thickness is in a direction of the resultant z' axis, and the resonator having a first order temperature coefficient α of approximately zero around room temperature.

According to the present invention, in a second aspect, there is provided a torsional quartz crystal tuning fork resonator vibratable in a torsional mode, comprising: a vibrational portion having a tuning fork shape having top and bottom faces; a bridge portion connected to an intermediate part of the vibrational portion; a supporting portion connected to the bridge portion and having a mount on an end of the supporting portion; and a pair of excitation electrodes of opposite polarities disposed on at least one of the top and bottom faces of the vibrational portion adjacent to one another; characterised in that the resonator is formed from a quartz crystal plate which is defined by rotating a z plate around an x-axis at an angle in the range of -50° through +30° and by further rotating the same around a resultant z'-axis at another angle in the range of -30° through -10° or +10° through +30°, the resonator having a thickness-to-width ratio (Rzx) within the range of 0.1 through 1.5 where width is in a direction of the resultant x' axis and thickness is in a direction of the resultant z' axis, and the resonator having a first order temperature coefficient α of approximately zero around room temperature.

Embodiments of the present invention will now be described with reference to the accompanying drawings, of which:
Fig. 1 is a schematic diagram showing the coordinate system of the torsional quartz crystal resonator according to the present invention;
Fig. 2A is a graph showing the relation between cut angles φ, θ and a thickness-to-width ratio Rzx of the torsional quartz crystal resonator of the present invention in which the first order temperature coefficient α is set to zero;
Fig. 2B is a graph showing the relation between the second order temperature coefficient β and the cut angle φ in the Fig. 2A resonator;
Fig. 3A is another graph showing the relation between the cut angles φ, θ and the thickness-to-width ratio Rzx while the first order temperature coefficient α is set to zero;
Fig. 3B is another graph showing the relation between the second order temperature coefficient β and the cut angle φ in the Fig. 3A resonator;
Fig. 4 is a graph showing an example of the frequency temperature behaviour of the torsional quartz crystal resonator of the tuning fork type according to the present invention;
Fig. 5 is a graph showing another example of the frequency temperature behaviour;
Fig. 6A is a schematic diagram showing the torsional quartz crystal resonator of the tuning fork type formed from a quartz crystal plate having cut angles φ, θ determined according to the present invention;
Fig. 6B is a sectional diagram showing the electrode structure of the Fig. 6A resonator;
Fig. 7 is an overall view showing a shape and an excitation electrode arrangement of another embodiment of the torsional quartz crystal resonator according to the present invention;
Fig. 8 is a graph showing the relation between a piezoelectric constant e₁₆ and the cut angle φ of the resonator according to the present invention, where the other cut angle θ is set as a parameter; and
Fig. 9 is a graph showing the relation between the cut angle φ and the frequency constant f. yₒ, where the other cut angle θ is set as a parameter in the torsional quartz crystal resonator of the tuning fork type according to the present invention.

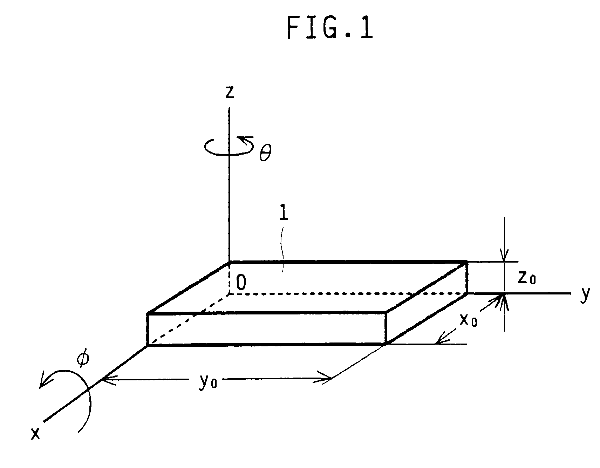

Fig. 1 shows the coordinate system of the torsional quartz crystal resonator of the present invention. The coordinate system 0-xyz comprises an origin point 0, an electrical axis x, a mechanical axis y and an optical axis z. An original torsional quartz crystal resonator 1 has a dimension of a thickness zₒ, a width xₒ and a length yₒ and a torsional moment around the y axis. This original resonator is defined along a z plate quartz crystal which is normal to the z axis.

Then, the original resonator is rotated around the x axis by an angle φ in the range from -90° to +90° where a counterclockwise direction is denoted by a plus sign such that the rotated resonator has a new z axis, i.e., z' axis. Further, the resonator is rotated around the z' axis by another angle θ in the range ±(10° through 80°), thereby defining the inventive resonator of a new cut which is hereinafter referred to as "TT cut".

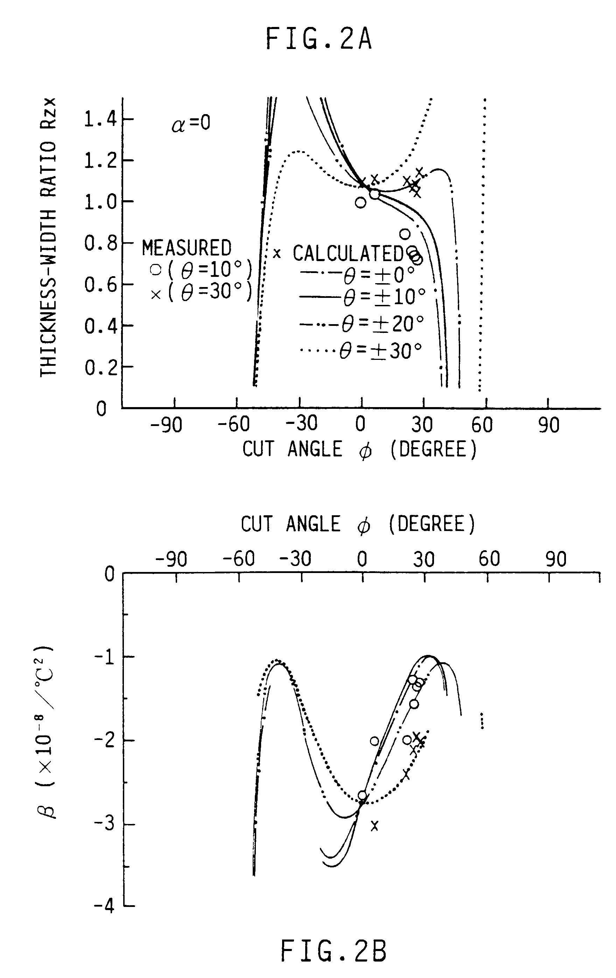

The cut angles φ, θ and the thickness-to-width ratio Rzx = zₒ/xₒ are optimumly determined to set the first order temperature coefficient α to zero. Fig. 2A shows the relation between the cut angles φ, θ and the thickness-to-width ratio Rzx, which are set to establish the condition that the first order temperature coefficient α equals zero in the torsional quartz crystal resonator of the present invention.

Fig. 2B shows the relation between the second order temperature coefficient β and the cut angle φ under the condition α=0. These graphs indicate calculated values while the cut angle θ is set to 0°, ±10°, ±20° and ±30° as a parameter, and measured values where the cut angle θ is fixed to 0°, ±10°, ±20° and ±30°. As understood from the Fig. 2A graph, the condition α = 0 can be established by suitably selecting the thickness-to-width ratio Rzx while the cut angle φ ranges -50° through + 60° in case of θ =±(0° through 30°).

As seen from Fig. 2B, the absolute value of β takes a minimum level around φ =30° when the cut angle θ is set to ±10°. For example, while α=0 is held when φ =28° and θ=±10°, the calculated value of β is -1.16x10⁻⁸/°C² and the measured value of β is -1.29x 10⁻⁸/°C² with respect to the resonator of the tuning fork type. Thus, the absolute value of the calculated and measured β is significantly smaller than that of the flexural mode quartz crystal resonator (β = -3.8x10⁻⁸/°C²) by about one-third. Further, the condition α=0 is held at φ =-42° and θ =±30°, while the calculated value of β is -1.06x10⁻⁸/°C² and the measured value is -1.22x10⁻⁸/°C^{2.} In this case, the absolute value of β can be significantly reduced.

In general, the condition α=0 is obtained in the range of φ=-50° through + 60° by suitably setting the other cut angle θ and the thickness-to-width ratio Rzx, while the value of β is reduced in the range of -1.2x10⁻⁸/°C² through -3.7x10⁻⁸/°C². Since the absolute value of β can be made small, there can be obtained a torsional quartz crystal resonator having excellent frequency temperature behaviour.

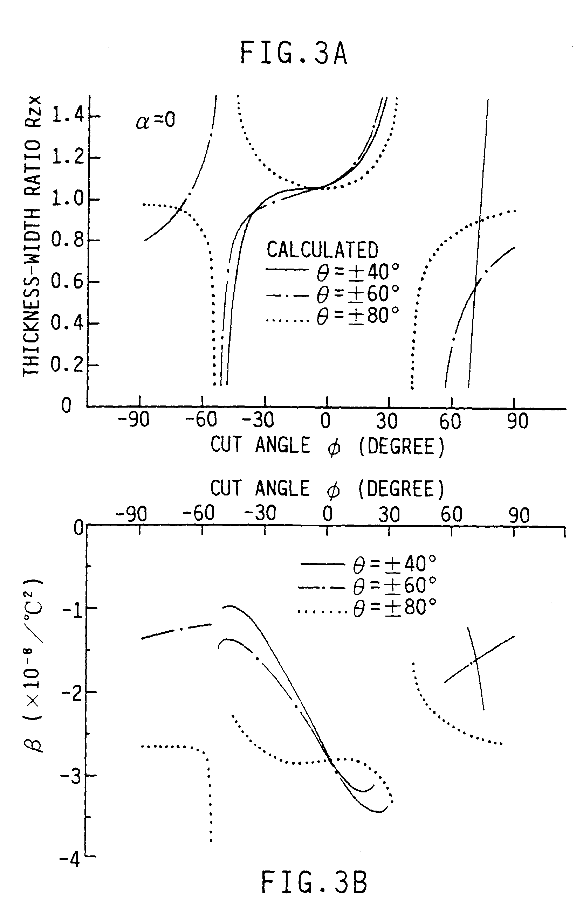

Figs. 3A and 3B show similar relations as shown in Figs. 2A and 2B graphs for the same torsional quartz crystal resonator of the tuning fork type, where the parametric cut angle θ is further set greater to ±40°, ±60° and ±80°. Namely, the Fig. 3A graph shows the relation between the cut angles φ, θ and the thickness-to-width ratio Rzx, set to satisfy the condition α=0. Fig. 3B shows the value of the second order temperature coefficient β under the condition α=0. Except for the range of around φ=35° where the condition α=0 is not realised, the condition α=0 can be achieved generally in the range of φ=-90° through +90° by suitably selecting the thickness-to-width ratio Rzx. Further as seen from Fig. 3B, the value β can take a relatively low value in the range of -1.0x10⁻⁸/°C² through -3.8x10⁻⁸/°C² as in the case of θ=±(0° through 30°), thereby obtaining a torsional quartz crystal resonator of the tuning fork type having a good frequency temperature behaviour.

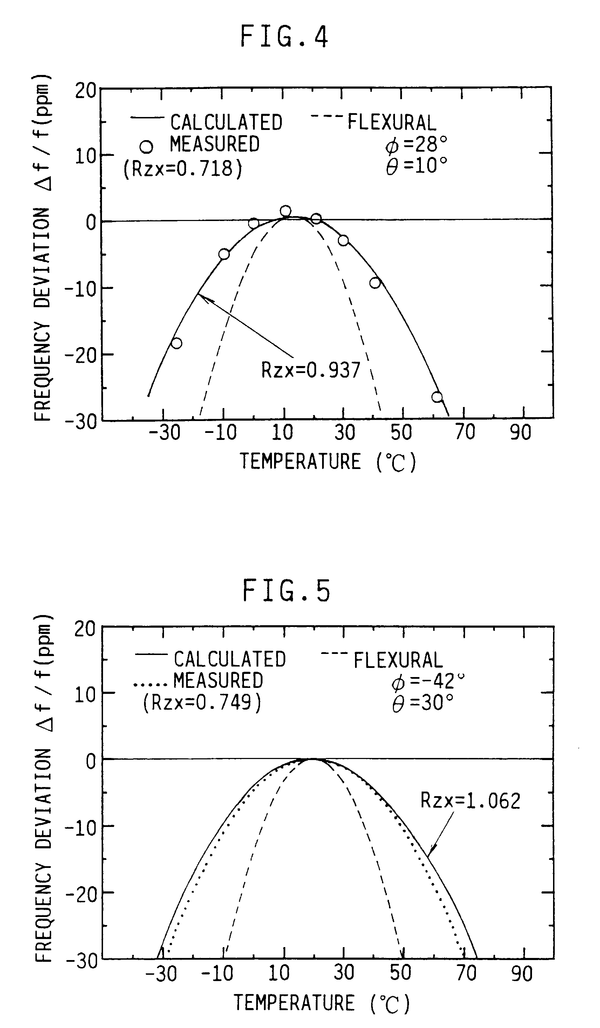

According to the present invention, the condition α=0 can be established by selecting the cut angle φ in the range of -90° through + 90°, by selecting the other cut angle θ in the range of ±(0° through 80°) and by selecting the ratio Rzx in the range of 0.1 through 1.5. Typical temperature behaviour of the thus defined resonator is shown in Figs. 4 and 5. Fig. 4 is a graph showing one example of the frequency temperature behaviour of the tuning fork type of the torsional quartz crystal resonator of the present invention having cut angles of φ=28° and θ = 10°. The solid line curve indicates the calculated value of the frequency deviation Δf/f, and circle points indicate the measured values. On the other hand, the broken line curve indicates the frequency temperature behaviour of the conventional flexural mode quartz crystal resonator. As appreciated from the Fig. 4 graph, the torsional quartz crystal resonator of the present invention of the tuning fork type has a better frequency temperature behaviour.

Fig. 5 shows another example of the frequency temperature behaviour of such a tuning fork type quartz crystal resonator having cut angles of φ=-42° and θ=30°. As in Fig. 4 case, it is understood from the Fig. 5 graph that the tuning fork type torsional quartz crystal resonator of the present invention has a better frequency temperature behaviour as compared to the conventional flexural mode quartz crystal resonator.

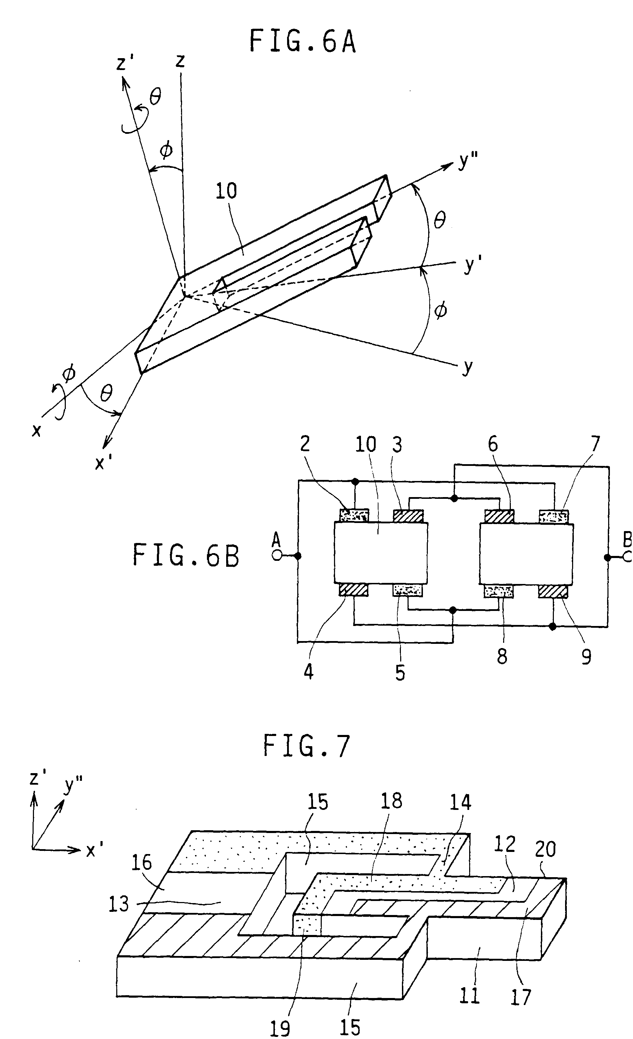

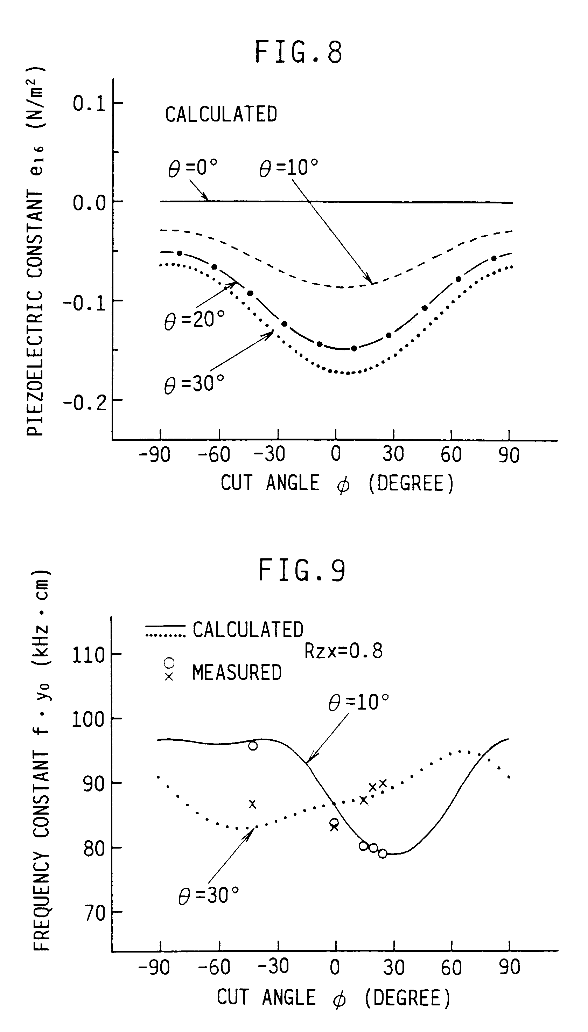

Fig. 6A shows a perspective view of the tuning fork type torsional quartz crystal resonator formed from a quartz crystal plate having the cut angles φ, θ set according to the invention. Fig. 6B shows a section of the same resonator, illustrating the electrode structure. The resonator has a pair of electrode terminals A and B. The one terminal A is connected to electrodes 2, 5, 7 and 8, and the other terminal B is connected to electrodes 3, 4, 6 and 9. In this electrode structure, the torsional quartz crystal resonator 10 is excited according to a piezoelectric constant e₁₆. Fig. 8 shows the relation between piezoelectric constant e₁₆ and the cut angles φ, θ.

Fig. 7 is a perspective view showing a shape and an exciting electrode arrangement of another embodiment of the torsional quartz crystal resonator of the present invention. A resonator 11 comprises a vibrational portion 12 having excitation electrodes 17, 18, 21 and 22 (the electrodes 21 and 22 and hidden from the view) and connecting electrodes 19,20 (the electrode 20 is hidden from the view), and a supporting portion 13 connected to the vibrational portion through a pair of bridge portions 14. The supporting portion 13 comprises a frame 15 coupled to the bridge portions 14 disposed at the central part of the vibrational portion 12, and coupled to a mount 16.

The excitation electrode 17 is formed on a top face of the vibrational portion 12. The connecting electrode 20 is disposed on an etched face which is formed by an etching process for connecting between the excitation electrode 17 and the other excitation electrode 21 (not shown) which is formed on a bottom face of the vibrational portion 12 in opposed relation to the front excitation electrode 18. In similar manner, the front excitation electrode 18 is connected to the rear excitation electrode 22 (not shown) formed in opposed relation to the front excitation electrode 17, through the other connecting electrode 19 formed on the etched face. The pair of excitation electrodes 17, 18 of the opposite polarities are extended along the frame 15 to the mount 16 for external electrical connection. An alternating voltage is applied between the end terminals of the pair of excitation electrodes 17, 18 to efficiently induce a torsional vibration.

By such construction of the resonator, the series resistance R₁ can be lowered, while the vibrational energy can be confined efficiently within the vibrational portion, thereby providing an improved quartz crystal resonator having excellent electric characteristics and free of vibrational leak. Further, though such a resonator has a rather complicated shape, the resonator can be formed easily by chemical etching process.

Fig. 8 shows the relation between the piezoelectric constant e₁₆ and the cut angle φ while the other cut angle θ is set as a parameter. As seen from the graph, the piezoelectric constant e₁₆ becomes zero at θ =0° in the entire range of cut angle φ: hence the present torsional quartz crystal resonator can not be excited. However, the absolute value of e₁₆ gradually increases as the cut angle θ increases, so that the constant e₁₆ has a maximum value at θ =30°. Though not shown in the figure, when the cut angle θ is further increased, the absolute value of e₁₆ reversely and gradually decreases so that the absolute value of e₁₆ becomes minimum at θ =60°. When the cut angle is still further indicated increased, the absolute value of e₁₆ again increases. As understood from the above description, the torsional quartz crystal resonator having the cut angle θ=0° is not excited by the aforementioned electrode structure. Further, the absolute value of e₁₆ is extremely small in the cut angle range below θ =10°, hence the series resistance R₁ is rather great and is therefore not practical. Accordingly, the absolute cut angle θ is set not less than 10° so as to lower the series resistance R₁ in the present invention.

The description will now extend to micronization of the resonator. Fig. 9 shows the relation between the cut angle φ and the frequency constant f.yₒ with respect to the tuning fork type torsional quartz crystal resonator of the present invention having the thickness-to-width ratio Rzx = 0. 8. In this case the other cut angle θ is set as a parameter. Depending on the values of the cut angles φ, θ, the frequency ranges from 80 to 97 kHz.cm. This is greater than the typical value of 7.9 kHz.cm of the conventional tuning fork type flexural quartz crystal resonator having the thickness-to-width ratio of 0.1 but which is smaller than the typical value of 270 kHz.cm of the conventional length extensional mode quartz crystal resonator. Namely, the frequency constant of the tuning fork type torsional quartz crystal resonator of the present invention ranges between those of the flexural mode and the length extensional mode, so that the inventive resonator is particularly suitable for use in the frequency range from 200 kHz to 600 kHz.

The description will now concentrate on the typical electrical equivalent circuit parameters of the tuning fork type torsional quartz crystal resonator of the present invention. Table 1 below shows the typical parameters with respect to different samples of such a tuning fork type torsional quartz crystal resonator, having the cut angles φ = 0°, θ = 30° and the other cut angles φ = 26°, θ = 10°. When φ =0°, and θ=30°, the following data is obtained: frequency f=444.1 kHz, R₁=2.2 kΩ and Q =378,000. On the other hand, when φ=26°, θ=10°, the following data is obtained: f=385.8 kHz, R₁ = 14.4 kΩ and Q=276,000. Accordingly, it is now possible to obtain a resonator having a small value of R₁ and large value of Q. Further, it is understood from the value of e₁₆ that other excellent R₁ and Q values can be obtained in the various cut angle range of φ and θ besides the listed samples.

**Table 1**

| φ (DEG.) | θ (DEG.) | f (kHz) | R₁ (kΩ) | L₁ (kH) | Q (x10³) | C₀ (pF) | r |
|---|---|---|---|---|---|---|---|
| 0 | 30 | 444.1 | 2.2 | 0.30 | 378 | 0.425 | 984 |
| 26 | 10 | 385.8 | 14.4 | 1.64 | 276 | 0.434 | 4190 |

As described above, the torsional quartz crystal resonator of the TT cut according to the present invention can produce the following remarkable effects:
(1) The cut angle φ is set in the range from -90° to ±90°, the other cut angle θ is set in the range of ±(10° through 80°) and the thickness-to-width ratio Rzx is set in the range of 0.1 through 1.5, such that the first temperature coefficient α is set at zero thereby achieving an excellent frequency temperature behaviour.
(2) Particularly, the cut angles φ, θ and the thickness-to-width ratio Rzx are optimumly set to reduce the second order temperature coefficient β by about one-third of the conventional tuning type flexural mode quartz crystal resonator, thereby reducing variations in the frequency relative to the temperature as compared to the previously known flexural mode and the length extensional mode.
(3) The aforementioned resonator can be formed easily by an etching process when the cut angle φ ranges from -55° to +30° and the other cut angle θ ranges ±(10° through 80°), thereby reducing the size and the thickness of the resonator. Additionally, a plurality of resonator pieces can be produced at once by batch processing of one wafer, thereby lowering the production cost.
(4) The resonator of the present invention has a frequency range between the fundamental vibration mode of the tuning type flexural quartz crystal resonator and the length extensional mode quartz crystal resonator. Thus the resonator of present invention is particularly suitable in the range of 200 kHz through 600 kHz.
(5) The present invention can facilitate the micronization of the quartz crystal resonator.
(6) The excitation electrodes are disposed on the top and bottom faces of the resonator piece, thereby decreasing the series resistance R₁ and increasing the Q value of the torsional quartz crystal resonator.
(7) The resonator of the present invention can be shaped in as a tuning fork type or a free-free bar type such that the vibrational portion can be formed integrally with the supporting portion. This results in reducing the loss of vibrational energy which would otherwise be caused by the lead wires support, to produce a torsional quartz crystal resonator having good shock resistance.

## Claims

1. A torsional quartz crystal tuning fork resonator (10) vibratable in a torsional mode, characterised by the resonator having a specific cut type defined such that a z plate quartz crystal (1) normal to a z-axis is rotated around an x-axis by a cut angle φ in the range of -50° through +30°, and is further rotated around a resultant z'-axis by another cut angle θ in the range of -30° through -10° or +10° through +30° so as to form the torsional quartz crystal tuning fork resonator, the resonator having its length extending along a resultant y' axis, a thickness-to-width ratio (Rzx) within the range of 0.1 through 1.5, where width is in a direction of the resultant x' axis and thickness is in a direction of the resultant z' axis, and the resonator having a first order temperature coefficient α of approximately zero around room temperature.

2. A torsional quartz crystal tuning fork resonator according to claim 1; including an excitation electrode (2, 3, 4, 5, 6, 7, 8, 9) disposed on a face of the resonator which is normal to the z'-axis.

3. A torsional quartz crystal tuning fork resonator (10) vibratable in a torsional mode, comprising: a vibrational portion (12) having a tuning fork shape having top and bottom faces; a bridge portion (14) connected to an intermediate part of the vibrational portion; a supporting portion (13) connected to the bridge portion and having a mount (16) on an end of the supporting portion; and a pair of excitation electrodes (17, 18, 20, 22) of opposite polarities disposed on at least one of the top and bottom faces of the vibrational portion adjacent to one another; characterised in that the resonator is formed from a quartz crystal plate which is defined by rotating a z plate around an x-axis at an angle in the range of -50° through +30° and by further rotating the same around a resultant z'-axis at another angle in the range of -30° through -10° or +10° through +30°, the resonator having a thickness-to-width ratio (Rzx) within the range of 0.1 through 1.5 where width is in a direction of the resultant x' axis and thickness is in a direction of the resultant z' axis, and the resonator having a first order temperature coefficient α of approximately zero around room temperature.

4. A torsional quartz crystal tuning fork resonator according to claim 3; wherein the vibrational portion and the supporting portion are formed integrally with one another by chemical etching of the z plate.

## Patentansprüche

1. Torsions-Quarzkristall-Stimmgabelresonator (10), der in einem Torsionsmodus schwingen kann,
**dadurch gekennzeichnet**, daß der Resonator einen speziellen Schnittyp aufweist, welcher derart definiert ist, daß ein z-Platten-Quarzkristall (1), der normal zu einer z-Achse ist, um eine x-Achse um einen Schnittwinkel φ im Bereich von -50° bis +30° gedreht ist und ferner um eine resultierende z'-Achse um einen weiteren Schnittwinkel θ im Bereich von -30° bis -10° oder +10° bis +30° gedreht ist, um den Torsions-Quarzkristall-Stimmgabelresonator zu bilden, wobei der Resonator eine sich längs einer resultierenden y'-Achse erstreckende Länge aufweist, ein Dicke-zu-Breite-Verhältnis (Rzx) im Bereich von 0,1 bis 1,5 aufweist, wobei sich die Breite in einer Richtung der resultierenden x'-Achse und die Dicke sich in einer Richtung der resultierenden z'-Achse erstreckt, und wobei der Resonator im Bereich der Raumtemperatur einen Temperaturkoeffizienten α erster Ordnung von näherungsweise Null aufweist.

2. Torsions-Quarzkristall-Stimmgabelresonator nach Anspruch 1, umfassend eine Anregungselektrode (2, 3, 4, 5, 6, 7, 8, 9), die auf einer Seite des Resonators angeordnet ist, welche normal zur z'-Achse ist.

3. Torions-Quarzkristall-Stimmgabelresonator (10), der in einem Torsionsmodus schwingen kann, umfassend: einen Schwingabschnitt (12) mit einer Stimmgabelform mit einer Oberseite und einer Unterseite; einen Brückenabschnitt (14), der mit einem Zwischenteil des Schwingabschnitts verbunden ist; einen Halteabschnitt (13), der mit dem Brückenabschnitt verbunden ist und an einem Ende des Halteabschnitts einen Träger (16) aufweist; und ein Paar von Anregungselektroden (17, 18, 20, 22) entgegengesetzter Polaritäten, die einander benachbart auf wenigstens einer Seite von Oberseite und Unterseite des Schwingabschnitts angeordnet sind;
**dadurch gekennzeichnet**, daß der Resonator aus einer Quarzkristallplatte gebildet ist, die definiert ist durch Drehen einer z-Platte um eine x-Achse um einen Winkel im Bereich von -50° bis +30° und durch weiteres Drehen derselben um eine resultierende z'-Achse um einen weiteren Winkel im Bereich von -30° bis -10° oder +10° bis +30°, wobei der Resonator ein Dicke-zu-Breite-Verhältnis (Rzx) im Bereich von 0,1 bis 1,5 aufweist, wobei die Breite sich in einer Richtung der resultierenden x'-Achse und die Dicke sich in einer Richtung der resultierenden z'-Achse erstreckt, und wobei der Resonator im Bereich der Raumtemperatur einen Temperaturkoeffizienten α erster Ordnung von näherungsweise Null aufweist.

4. Torsions-Quarzkristall-Stimmgabelresonator nach Anspruch 3, wobei der Schwingabschnitt und der Halteabschnitt durch chemisches Ätzen der z-Platte integral miteinander ausgebildet sind.

## Revendications

1. Résonateur (10) de diapason à cristal de quartz de torsion, pouvant vibrer selon un mode de torsion, caractérisé par le fait que le résonateur a un type de coupe spécifique défini de telle sorte qu'un cristal (1) de quartz plat par rapport à z et perpendiculaire à l'axe z tourne par rapport à un axe x d'un angle de coupe φ du domaine allant de -50° à +30°, et tourne de plus par rapport à un axe z' résultant, d'un autre angle de couple θ dans le domaine allant de -30° à -10° ou de +10° à + 30°, de façon à former le résonateur de diapason à cristal de quartz de torsion, le résonateur ayant sa longueur s'étendant le long d'un axe y' résultant, un rapport épaisseur sur profondeur (Rzx) compris entre 0,1 et 1,5, la profondeur se trouvant dans la direction de l'axe x' résultant et l'épaisseur se trouvant dans la direction de l'axe z' résultant, et le résonateur ayant un coefficient α de température du premier ordre approximativement égal à 0 au voisinage de la température ambiante.

2. Résonateur de diapason à cristal de quartz de torsion suivant la revendication 1, comprenant une électrode d'excitation (2,3,4,5,6,7,8,9) disposée sur une face du résonateur qui est perpendiculaire à l'axe z'.

3. Résonateur (10) de diapason à cristal de quartz de torsion, pouvant vibrer selon un mode de torsion, comprenant : une partie (12) de vibration, ayant une forme de diapason à face supérieure et inférieure ; une partie (14) de pont reliée à une partie intermédiaire de la partie de vibration ; une partie (13) de support reliée à la partie de pont et ayant une monture (16) à une extrémité de la partie de support ; et une paire d'électrodes (17,18, 20,22) d'excitation de polarités opposées disposées sur au moins l'une des faces supérieure et inférieure de la partie de vibration de manière à être adjacente l'une à l'autre ; caractérisé en ce que le résonateur est formé d'une plaque de cristal de quartz qui est définie par la rotation d'une plaque normale à z par rapport à un axe x, d'un angle du domaine allant de -50° à + 30° et par une rotation supplémentaire de cette même plaque par rapport à un axe z' résultant, d'un autre angle du domaine allant de -30° à -10° ou de +10° à +30°, le résonateur ayant un rapport épaisseur sur profondeur (Rzx) compris dans le domaine allant de 0,1 à 1,5, la profondeur se trouvant dans la direction de l'axe x' résultant et l'épaisseur se trouvant dans la direction de l'axe z' résultant, et le résonateur ayant un coefficient α de température de premier ordre d'approximativement 0 au voisinage de la température ambiante.

4. Résonateur de diapason à cristal de quartz de torsion suivant la revendication 3, dans lequel la partie de vibration et la partie de support sont formées d'une seul pièce l'une avec l'autre par attaque chimique de la plaque normale à z.
